**Europäisches Patentamt**

**European Patent Office**

**Office européen des brevets**

(19)

(11) Numéro de publication : **0 101 359**
**B1**

(12)

# FASCICULE DE BREVET EUROPÉEN

(45) Date de publication du fascicule du brevet :
**10.02.88**

(21) Numéro de dépôt : **83401545.5**

(22) Date de dépôt : **27.07.83**

(51) Int. Cl.⁴ : **H 01 R  9/09, H 05 K  5/02,**
**H 05 K  7/02, H 05 K  3/36**

---

(54) **Boîtier d'interconnexion.**

---

(30) Priorité : **09.08.82 FR 8213846**

(43) Date de publication de la demande :
**22.02.84 Bulletin 84/08**

(45) Mention de la délivrance du brevet :
**10.02.88 Bulletin 88/06**

(84) Etats contractants désignés :
**DE GB IT**

(56) Documents cités :
**DE-A- 3 042 585**
**FR-A- 2 307 440**
**FR-A- 2 335 075**
**FR-A- 2 344 151**
**GB-A- 1 226 224**
**GB-A- 1 354 708**
**US-A- 4 184 730**
**ELECTRONICS INTERNATIONAL, vol. 50, no. 19, 15**
**septembre 1977, pages 97-105, New York, USA, J.**
**LYMAN: "Flexible circuits bend to designers' will"**

(73) Titulaire : **DAV INDUSTRIES**
**Vétraz-Monthoux BP 85**
**F-74101 Annemasse Cédex (FR)**

(72) Inventeur : **Viennois, Jean-Paul**
**13, rue de l'Isle de France**
**F-74100 Annemasse (FR)**
Inventeur : **Baudry, Jean-Pierre**
**Vert Village No. 41 Cranves-Sales**
**F-74380 Bonne (FR)**
Inventeur : **Albert, Paul**
**Allée des Garennes Vétraz-Monthoux**
**F-74100 Annemasse (FR)**
Inventeur : **Fadla, Roger**
**Lieu-dit "Les Donnes" Cranves-Sales**
**F-74380 Bonne (FR)**

(74) Mandataire : **Loriot, Jacques et al**
**c/o SA. FEDIT-LORIOT 38, avenue Hoche**
**F-75008 Paris (FR)**

---

## Description

La présente invention concerne un boîtier d'interconnexion et, plus particulièrement, un boîtier d'interconnexion destiné à des véhicules automobiles.

Le boîtier d'interconnexion comprend généralement un circuit imprimé dont les différents circuits électriques sont utilisés pour l'alimentation en courant électrique de certains accessoires du véhicule automobile. L'utilisation d'un tel boîtier réduit considérablement l'encombrement comparé au faisceau de câbles utilisés précédemment. De plus, le boîtier peut être incorporé dans le compartiment moteur plutôt que dans le compartiment habitacle du véhicule.

Les accessoires à commander devenant de plus en plus nombreux, il s'ensuit qu'il s'avère nécessaire d'alimenter davantage de circuits électriques.

Pour répondre à toutes ces exigences, on a proposé dans le brevet FR-7 814 912 un boîtier de connexion principal comprenant un empilage de plaques de circuits constituant en fait le circuit imprimé, avec un isolant interposé entre deux plaques adjacentes. La difficulté pour réaliser un tel boîtier de connexion réside dans le procédé de raccordement électrique et d'organes de connexion avec les circuits internes. Un moyen proposé est de raccorder ceux-ci par enfichage au travers des circuits et du boîtier. Ce moyen requiert une réalisation minutieuse et la mise au point d'un procédé de fabrication particulier pour permettre notamment un bon contact électrique tout en assurant l'alignement des organes de connexion.

Le brevet GB-A-1 354 708 concerne des circuits imprimés dans lesquels on peut utiliser des bandes en plastique afin de pouvoir plier lesdits circuits imprimés. Toutefois ils comportent une structure spéciale dans laquelle sont insérés des connecteurs tous de même longueur, ce qui leur interdit de recevoir un empilage de circuits sur différents connecteurs.

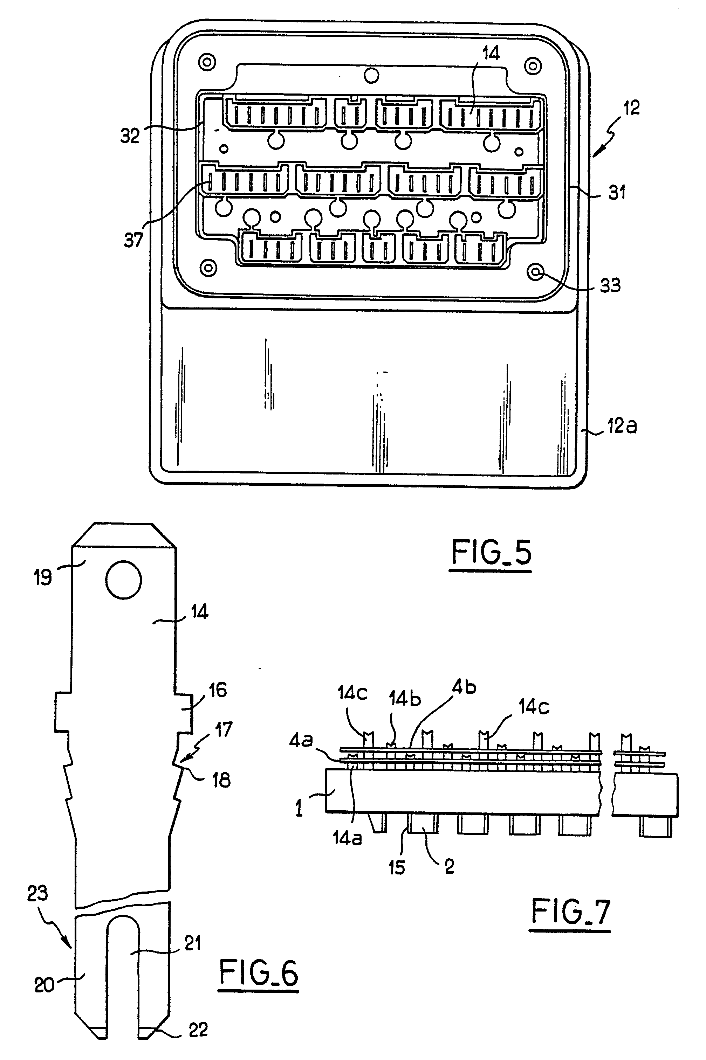

Dans la revue Electronics International (vol. du 15 septembre 1977) un article rédigé par Jerry Lyman concerne des circuits souples qui ne peuvent recevoir que des circuits appropriés, comme cela est représenté sur les figures 7 à 9 de l'article, chacun des circuits à enficher comportant des connecteurs de même longueur ; de ce fait, il n'est guère aisé de prévoir des boîtiers à plusieurs couches superposées de circuits, distincts des autres et remplissant des fonctions bien déterminées.

Le brevet DE-A-3 042 585 concerne des circuits rigides, comprenant chacun les éléments électroniques, la liaison entre les circuits étant effectuée au moyen de fils qui sont repliables pour positionner correctement les circuits l'un par rapport à l'autre, et par rapport à une plaque de base de laquelle partent des connecteurs de même longueur. Ainsi, dans chaque boîtier qui peut comprendre, à la limite, plus de deux circuits rigides, ce sont les mêmes connecteurs de la base qui relieront les circuits. Il n'est donc pas possible d'affecter à chaque circuit des connecteurs spécifiques pour une fonction précise.

Le brevet GB-A-1 226 224 concerne un dispositif qui comprend plusieurs séries d'organes de connexions, de longueurs différentes, chaque série d'organes étant solidaires d'une plaque de circuit imprimé, les diverses plaques de circuit imprimés étant situées les unes au-dessus des autres. Toutefois, les boîtiers d'interconnexion de l'art antérieur même équipés du dispositif selon le brevet GB-A-1 226 224 restent encombrants et peu performants.

La présente invention a donc pour objet de proposer un boîtier d'interconnexion qui s'affranchit de ces inconvénients, convenant pour tous les types de courant, faible et élevé, capable de recevoir un empilage de plaques de circuits dans un encombrement réduit, avec des chutes de tension minimales dans les liaisons électriques, et qui puisse être réalisé à partir de moyens de production de grande série pour un prix de revient avantageux.

Le boîtier d'interconnexion selon l'invention est tel qu'il est défini par la revendication 1.

Un avantage de la présente invention est de pouvoir monter les organes de connexion en insertion automatique sur les embases à l'état nu.

Un autre avantage lié à la possibilité de pliage des circuits réside dans le fait qu'une partie du boîtier de connexion peut être logée dans le compartiment moteur, tandis que l'autre partie peut constituer une traversée de tablier et être accessible de l'habitacle ; de plus, cela permet d'avoir accès directement à des sorties sur plusieurs faces du boîtier.

D'autres avantages et caractéristiques ressortiront mieux à la lecture de la description donnée ci-dessous à titre indicatif mais non limitatif d'un mode de réalisation préféré de la présente invention ; ainsi que du dessin annexé sur lequel :

la figure 1 est une vue schématique éclatée du boîtier d'interconnexion selon l'invention, à l'état déplié ;

les figures 2a et 2b sont des vues en plan des deux faces d'une plaque dans laquelle sont réalisés des circuits électriques distincts ;

la figure 3 est une vue en coupe du boîtier de la figure 1, mais à l'état replié ;

la figure 4 est une vue de dessus de la partie du boîtier logée dans le compartiment moteur ;

la figure 5 est une vue de dessus de l'autre partie du boîtier ;

la figure 6 est une vue de dessus d'un connecteur mâle ;

la figure 7 est une vue schématique d'un empilage de plaques ;

la figure 8 est une vue de face du connecteur femelle ;

la figure 9 est une vue de côté du connecteur femelle représenté sur la figure 7.

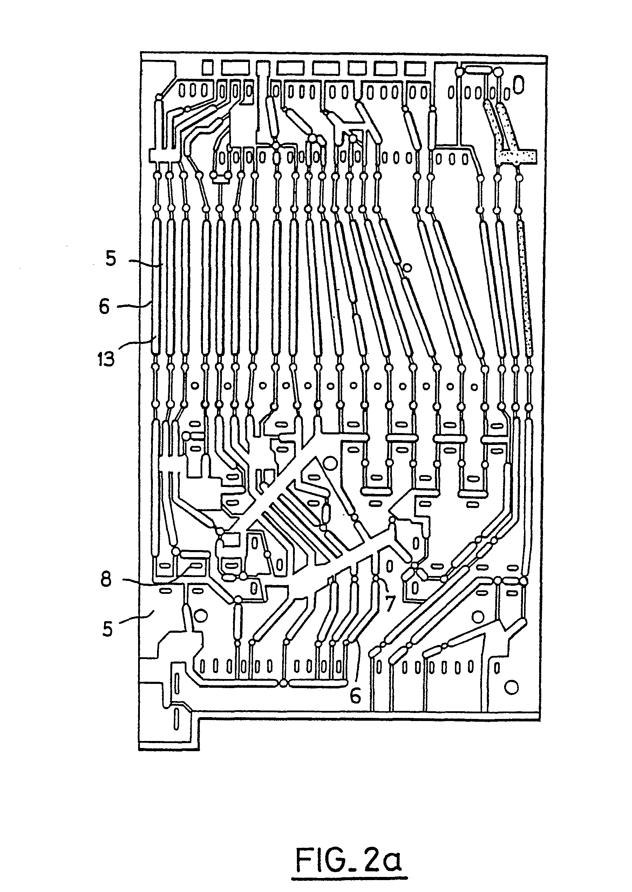

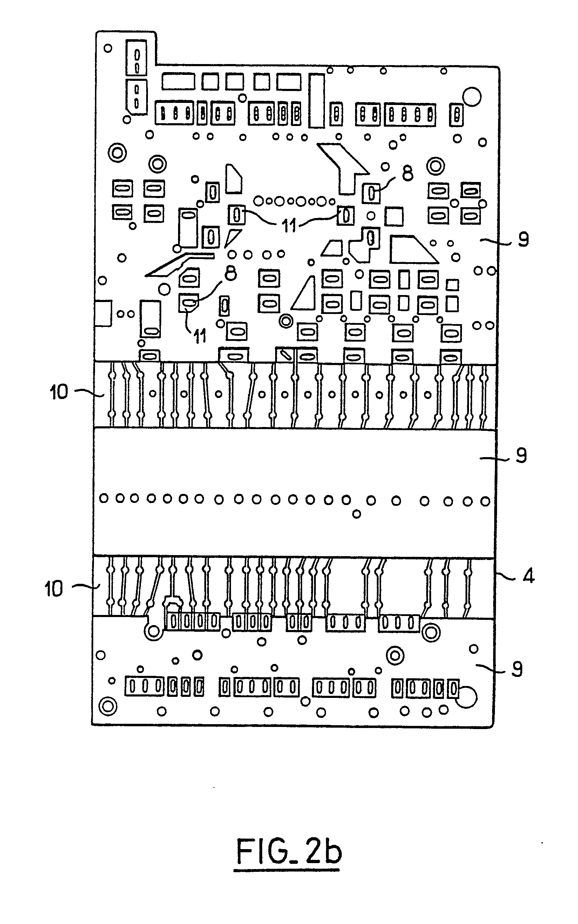

Le boîtier d'interconnexion comprend une embase en matière plastique moulée 1 dans laquelle sont ménagés des logements 2 pour la réception de plusieurs types d'organes de connexion électriques mâles 14 et femelles 40 qui sont tous fixés sur ladite embase 1 avant montage du circuit imprimé désigné dans son ensemble par la référence 3. Le circuit imprimé 3 (figure 2a) est constitué par au moins une plaque métallique 4 dans laquelle sont découpées par tout moyen approprié chimique ou mécanique des pistes ou bandes séparées 5 constituant chacune un circuit électrique. Les passages ou découpes 6 ménagés entre les circuits 5 sont reliés entre eux par des pontets de liaison mécaniques 7 qui sont ultérieurement enlevés par emboutissage, notamment en fonction des liaisons à réaliser entre lesdits circuits 5. Des orifices 8 sont également ménagés pour l'introduction des extrémités des organes de connexion électriques devant être solidarisés avec la plaque métallique 4. Sur la face opposée de la plaque 4, représentée sur la figure 2b on surmoule une couche d'isolant 9 qui recouvre toute la plaque 4 sauf en une ou plusieurs zones 10 et autour desdits orifices 8 de manière à créer autour de ces derniers des évidements 11.

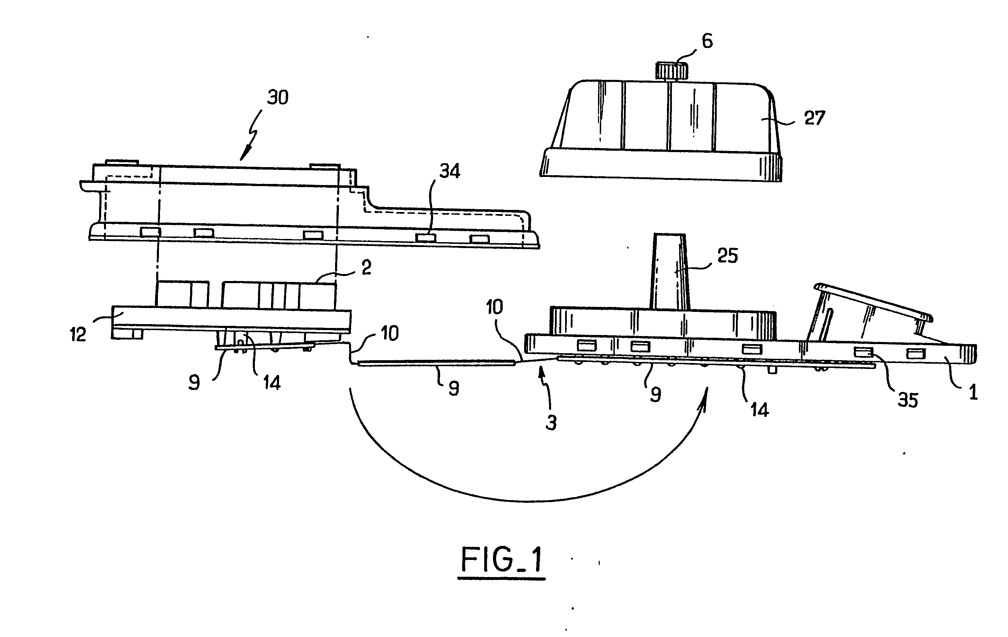

A l'autre extrémité de la plaque 4 (figure 1) est également prévue une seconde embase 12 pourvue de logements 2 pour l'insertion d'organes de connexion électriques.

Lors du surmoulage de l'isolant 9 sur la plaque 4, on réalise ledit surmoulage de façon que l'isolant pénètre dans les passages ou découpes 6 de manière à former des bourrelets 13 qui recouvrent une petite partie des circuits électriques adjacents, du côté de la face de la plaque non recouverte par l'isolant.

La plaque surmoulée 4 est disposée sur les organes de connexion 14 et 40 de façon que la face dénudée soit en regard des embases 1 et 12. Après quoi, on déplace l'ensemble constitué par les embases 1, 12 et la plaque 4 ainsi montée au-dessus d'un bain de soudure de façon que ladite soudure pénètre seulement dans les évidements 11 réalisant la liaison électrique des extrémités des organes de connexion 14 et 40 avec la plaque métallique 4 sur la surface nue métallique ménagée dans lesdits évidements 11.

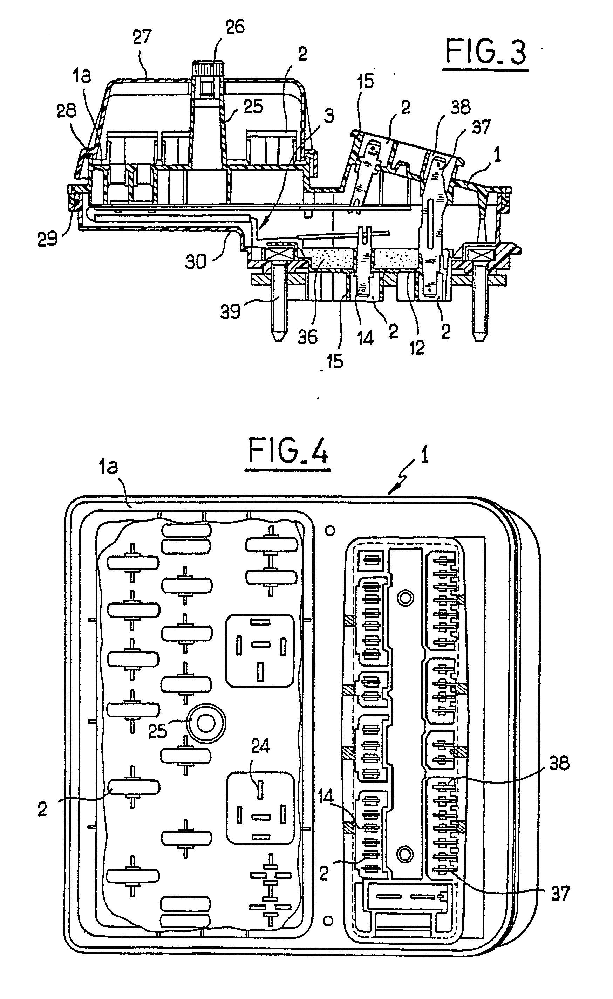

Lorsque la fixation de la plaque 4 sur les organes de connexion 14 et 40 est ainsi réalisée, on plie la plaque 4 le long des zones dénudées 10 de manière à amener l'embase 12 au-dessus de l'embase 1, comme cela est représenté sur la figure 3. Les différents logements 2 peuvent être protégés par des parties en relief 15 venues de moulage avec les embases 1 et 12.

Afin de permettre un surmoulage de l'isolant sur la plaque 4, tout en assurant la possibilité d'une soudure à la vague qui implique une bonne tenue de l'isolant aux températures développées par ladite soudure à la vague sans entraîner une déformation de la plaque, l'isolant est constitué par une matière thermodurcissable injectable telle qu'un polyester chargé de fibres de verre.

De plus, la structure de la plaque 4 revêtue sur une face de l'isolant permet d'avoir une plaque toujours rigide même après pliage. En effet, les zones dénudées 10 qui autorisent le rabattement d'une partie de la plaque vers l'autre partie sont réalisées de telle façon que combinées à la nature du métal de la plaque et à l'épaisseur des bandes ou pistes, cette dernière ne tend pas à revenir à l'état déplié. Ainsi, on obtient une rigidité d'ensemble de bonne qualité, chaque plaque pouvant néanmoins être repliée en fonction de l'encombrement souhaité du boîtier.

Dans le cas d'une boîte d'interconnexion comprenant sur au moins une des embases un empilage de plaques 4 constituant le circuit imprimé proprement dit, les connecteurs 14 et 40 sont de différentes longueurs, comme cela apparaît sur la figure 7. Une première série de connecteurs 14a correspondent à la plaque 4a qui se trouve la plus près de l'embase 1. Lorsque cette plaque 4a est fixée par soudure à la vague, comme décrit ci-dessus, sur les connecteurs 14a qui sont sur la figure, ceux qui présentent la plus petite hauteur, la plaque 4a est donc rendue solidaire de l'embase correspondante 1 ; on dispose ensuite la seconde plaque 4b qui est fixée par soudure à la vague sur les connecteurs 14b ; ces derniers présentent une hauteur supérieure à celle des connecteurs 14a ; les derniers connecteurs 14c de plus grande hauteur sont solidaires d'une plaque 14c qui se trouve alors la plus éloignée de ladite embase, par rapport aux autres plaques 14a et 14b qui sont entre ladite plaque 14c et ladite embase 1. Quel que soit le nombre de plaques empilées, la fixation desdites plaques est réalisée de la manière ci-dessus et dans l'ordre indiqué, avec toujours la face dénudée de chaque plaque tournée vers l'embase. Un même connecteur 14b ou 14c, par exemple est susceptible d'être utilisé successivement pour la fixation de plusieurs plaques et ainsi d'assurer l'interconnexion desdites plaques entre-elles. C'est ainsi que les connecteurs 14b traversent les plaques 4a et 4b, tandis que les connecteurs 14c traversent les plaques 14a à 14c. Ce procédé de fixation permet d'automatiser la fabrication des boîtiers d'interconnexion.

Chaque connecteur mâle 14 se présente sous la forme d'une languette introduite par la pointe dans le réceptacle 2 correspondant. La languette 4 (figure 6) comprend un rebord annulaire 16 formant appui et des redents 17 qui, par leurs angles vifs 18, prennent appui sur le bord du réceptacle et constituent l'élément de fixation desdites languettes dans leur logement. L'extrémité 19 est accessible d'un côté de l'embase, à travers les parties en relief 15, tandis que l'autre extrémité 20 se termine en forme de fourche 23 qui comprend une fente 21 et se termine en biseau 22 formant un angle de 45° par rapport à l'horizontale. La fourche 23 permet un meilleur contact de la soudure tandis que le biseau 22 permet, lors de la soudure à la vague, de canaliser la soudure vers le fond de l'évidement 11 et de s'étaler sur la partie métallique de la plaque non recouverte d'isolant.

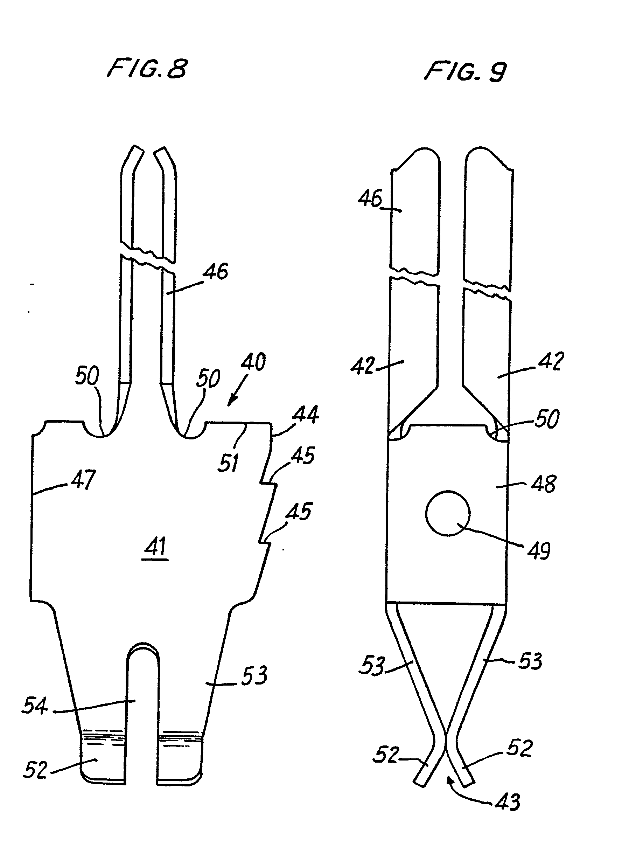

Des connecteurs femelles 40, pour la réception notamment de fusibles plats enfichables, sont également fixés sur la plaque métallique, suivant le procédé de soudure à la vague décrit à propos des connecteurs mâles 14. Les connecteurs femelles 40, représentés sur les figures 8 et 9, sont chacun constitués par deux éléments 41, 42 disposés en regard l'un de l'autre pour former à leur extrémité inférieure une pince élastique 43 (figure 9). Chaque élément 41, 42 comprend sur l'un de ses bords 44, des angles vifs 45 et une partie 46 destinée à être introduite dans l'orifice correspondant de la plaque 4. Les deux éléments 41, 42 sont réunis par leur autre bord 47 au moyen d'une petite plaque de liaison 48, percée d'un orifice 49, et disposée dans un plan sensiblement orthogonal aux plans définis par les parties verticales des éléments 41 et 42 comportant les angles vifs 45. Enfin, ils peuvent comprendre des dépouilles 50 sur leur bord supérieur 51, tandis que les parties recourbées à l'extérieur 52 des parties inclinées 53 formant pince forment un angle sensiblement égal à 60°. Enfin, chaque partie inclinée 53 comprend une fente 54.

Un connecteur femelle 40 est en réalité obtenu, en continu, par un procédé de découpage et de pliage d'une bande métallique.

Sur la partie 1a de l'embase 1 comprenant des logements 2 pour les connecteurs mâles 14 et des logements 24 pour les connecteurs femelles 40 destinés à des relais et/ou fusibles enfichables par exemple, il est prévu une petite colonne creuse 25 apte à recevoir, par vissage, une vis 26 solidarisant un capot de protection 27 de ladite partie 1a. Il va de soi que d'autres logements sont également prévus pour remplir des fonctions autres que celles mentionnées ci-dessus. Un joint d'étanchéité 28 est interposé entre le capot de protection 27 et l'embase 1. Un autre joint d'étanchéité 29 est également prévu au niveau de l'embase 12.

Un capot de fermeture 30 est fixé sur l'embase 12 et recouvre la partie 12a de la plaque 4 repliée de manière à compléter la protection de l'ensemble du circuit imprimé. A cet effet, le capot 30 comprend une ouverture 31 permettant le passage de la partie surmoulée 32 en relief de l'embase 12 dans laquelle sont ménagés les logements 2 avec les extrémités des languettes 14 accessibles de ce côté du boîtier. La fixation du capot 30 est assurée sur l'embase 12 par des moyens de fixation tels que vis 33 et sur l'embase 1 par des organes d'accrochage sous forme de tétons 34 susceptibles d'être insérés dans des orifices 35 ménagés dans ladite embase 1.

Enfin un écran anti-bruit de nature diélectrique 36 est interposé entre la plaque repliée 4 et le capot de fermeture 30.

Par ailleurs des languettes 37 beaucoup plus longues sont solidaires par une de leurs extrémités de l'embase 12 et s'introduisent par leur autre extrémité dans des logements 38 ménagés dans l'embase 1. Les languettes 37 assurent également une liaison entre les embases 1 et 12 mais ne traversent pas 1a ou les plaques 4.

Des vis 39 sont utilisées pour la fixation du boîtier d'interconnexion sur le tableau du véhicule.

**Revendications**

1. Boîtier d'interconnexion, du type comprenant au moins une embase moulée (1) en matière plastique sur laquelle sont fixés des organes de connexion (14) qui sont accessibles sur les deux faces opposées de ladite embase, au moins deux plaques rigides (4) situées d'un même côté de ladite embase et comportant chacune des pistes (5) ou bandes métalliques séparées formant chacune un circuit électrique et des orifices (8) pour le passage et la liaison desdits organes de connexion à ladite plaque, plusieurs séries d'organes de connexion (14, 14a, 14b) de longueurs différentes étant fixés sur ladite embase, caractérisé en ce qu'il comprend une seconde embase moulée (12) sur laquelle sont fixés également des organes de connexion (37) accessibles sur les deux faces de ladite embase, les deux embases étant rabattues l'une vers l'autre pour former un ensemble compact, des moyens (37, 38) étant prévus pour assurer l'assemblage des deux embases et une liaison électrique, lesdits moyens étant constitués par des languettes de liaison directe (37) dont une extrémité est fixée sur une embase (12) tandis que l'autre extrémité est susceptible de s'insérer dans des logements (38) ménagés dans l'autre embase (1).

2. Boîtier selon la revendication 1, caractérisé en ce que les organes de connexion comprennent des connecteurs mâles (14) et femelles (40) comportant chacun un rebord d'appui annulaire (16, 44) et au moins un redent (18, 45) de blocage dont un côté est incliné sur l'axe longitudinal.

3. Boîtier selon la revendication 2, caractérisé en ce que chaque connecteur mâle comprend une languette dont l'extrémité (20) à relier par exemple par soudure à la vague, à la plaque se termine par un biseau (22) et comprend une fente (21).

4. Boîtier selon la revendication 3, caractérisé en ce que le biseau (22) fait un angle de 45° sur l'horizontale.

5. Boîtier selon la revendication 3, caractérisé en ce que la languette comprend plusieurs redents (45) formant des angles vifs d'appui sur les bords du logement dans lequel la languette est introduite.

6. Boîtier selon la revendication 2, caractérisé en ce que les connecteurs femelles (40) sont constitués chacun par deux éléments (46) assemblés le long d'un côté au moyen d'une petite plaque de liaison (48), l'autre côté opposé comprenant des angles vifs (45), la partie inférieure (52) de chaque élément étant conformée de façon que les deux parties inférieures en regard forment une pince élastique.

7. Boîtier selon l'une des revendications 1 à 6, du type dans lequel chaque plaque de circuits imprimés est repliable, recouverte sur une de ses faces par un isolant (9) et comprenant des évidements (11) ménagés dans l'isolant autour des orifices (8) de passage pour les organes de connexion (14), caractérisé en ce que chaque plaque (4) comprend une zone (10) dépourvue d'isolant sur les deux faces de façon que le pliage de la plaque soit réalisé dans ladite zone, et en ce qu'une des embases est fixée sur sensiblement toute la surface de la plaque comprise entre un bord et la zone de pliage, tandis que la seconde embase est fixée à une partie de la surface restante de la plaque.

8. Boîtier selon la revendication 9, caractérisé en ce qu'il comprend un couvercle disposé du côté de la seconde embase, ledit couvercle comportant une large ouverture pour permettre l'accès des organes de connexion de ladite seconde embase et des moyens d'accrochage répartis sur le pourtour et coopérant avec des éléments de réception prévus sur le pourtour de la première embase.

9. Boîtier selon l'une des revendications 1 à 8, caractérisé en ce qu'un écran isophonique (36) de nature diélectrique est interposé entre la ou les plaques et au moins l'une des embases.

10. Boîtier selon l'une des revendications 1 à 9, caractérisé en ce qu'il comprend un capot de protection, pour des fusibles et au moins un relais insérés dans des logements correspondants.

11. Boîtier selon la revendication 7, caractérisé en ce que l'isolant est une matière thermodurcissable injectable telle qu'un polyester chargé de fibres de verre.

## Claims

1. Connector box of a type comprising at least one moulded plastic base (1) onto which are fixed connection elements (14) which are accessible on both opposing surfaces of said base, at least two rigid boards (4) located at the same side of said base and each having paths (5) or separate metal bands each forming an electrical circuit and openings (8) for the passage and connection of said connection elements to said board, several series of connection elements (14, 14a, 14b) of different lengths being fixed on said base, characterised in that it comprises a second moulded base (12) onto which connection elements (37) are also fixed which are accessible on both sides of said base, the two bases being folded towards each other to form a compact unit, means (37, 38) being provided to permit the assembly of the two bases and electrical connection, said means being constituted by direct blade connectors (37), one end of which is fixed to one base (12) whereas the other end is capable of being inserted into receptacles (38) arranged in the other base (1).

2. Box according to claim 1 characterised in that the connection elements comprise male connectors (14) and female connectors (40) each having an annular support edge (16, 44) and at least one blocking edge (18, 45) one side of which is inclined along the longitudinal axis.

3. Box according to claim 2 characterised in that each male connector comprises a blade connector, the end (20) of which, which is to be joined, by wave soldering for example, to the board terminates in a bevel (22) provided with a slit (21).

4. Box according to claim 3 characterised in that the bevel (22) is at an angle of 45 degrees to the horizontal.

5. Box according to claim 3 characterised in that the blade connector has several edges (45) forming acute support angles at the edge of the receptacles into which the tongue is introduced.

6. Box according to claim 2 characterised in that the female connectors (40) are each constituted by two elements (46) joined along one side by means of a small connection board (48), the opposite side having acute angles (45), and the lower section (52) of each element being formed in such a way that the two lower opposing sections form an elastic clip.

7. Box according to one of claims 1 to 6 of a type in which each printed circuit board is foldable and covered on one of its surfaces by isolating material (9) and containing recesses (11) arranged in the isolating material around openings (8) for the passage of the connection elements (14), characterised in that each board (4) comprises a zone (10) which is not covered by isolating material on both surfaces so that folding of the board can be carried out in said zone, and in that one of the bases is fixed on almost all of the surface of the board between one edge and the folding zone, whereas the second base is fixed to a part of the surface on the board.

8. Box according to claim 9 characterised in that it comprises a cover arranged at the side of the second base, said cover having a large opening to permit access for the connection elements of said second base and locking means distributed around the circumference of the first base.

9. Box according to one of claims 1 to 8 characterised in that an isophonic dielectric screen (36) is included between the board or boards and at least one of the bases.

10. Box according to one of claims 1 to 9 characterised in that it comprises a protective cover for fuses and at least one relay inserted into corresponding receptacles.

11. Box according to claim 7 characterised in that the isolating material is an injectable thermoduric material such as polyester with glass fibre.

## Patentansprüche

1. Gehäuse für elektrische Verbindungen mit wenigstens einem als Kunststoff-Formteil ausgebildeten Sockelteil (1), an dem Verbindungsorgane (14) befestigt sind, die an den beiden entgegengesetzten Seiten des Sokkelteils zugänglich sind, mit wenigstens zwei steifen Platten (4), die auf ein und derselben Seite des Sockelteils angeordnet sind und deren jede getrennte metallische Bahnen oder Streifen (5), die jeweils einen elektrischen Stromkreis bilden, sowie Öffnungen (8) aufweist für den Durchtritt der genannten Verbindungsorgane und zu deren Verbindung mit der Platte, sowie mit mehreren Reihen von an dem Sockelteil befestigten Verbindungsorganen (14, 14a, 14b) unterschiedlicher Länge, dadurch gekennzeichnet, daß ein zweites als Formteil ausgebildetes Sockelteil (12) vorgesehen ist, an dem ebenfalls Verbindungsorgane (37) befestigt sind, die an beiden Seiten dieses Sockelteils zugänglich sind, wobei die beiden Sockelteile zur Bildung einer kompakten Einheit gegeneinander gebogen sind, und daß Mittel (37, 38) zum Zusammenfügen der beiden Sockelteile und zur Herstellung einer elektrischen Verbindung vorgesehen sind, die aus Zungen (37) zur direkten Verbindung bestehen, die mit einem Ende an einem (12) der Sockelteile fixiert sind, während das andere Ende in an dem anderen Sockelteil (1) gebildete Aufnahmen (38) einsetzbar ist.

2. Gehäuse nach Anspruch 1, dadurch gekennzeichnet, daß die Verbindungsorgane männliche und weibliche Steckverbinderteile (14 bzw. 40) umfassen, die jeweils einen ringförmigen Stützrand (16, 44) und wenigstens einen Blockierzahn (18, 45) mit einer gegenüber der Längsachse geneigten Seite besitzen.

3. Gehäuse nach Anspruch 2, dadurch gekennzeichnet, daß jedes der männlichen Steckverbinderteile eine Zunge besitzt, deren beispielsweise durch Schwallöten mit der genannten Platte verbindbarer Endbereich (20) in einem mit Abfasungen versehenden Kante (22) endet und einen Schlitz (21) aufweist.

4. Gehäuse nach Anspruch 3, dadurch gekennzeichnet, daß die mit Abfasungen versehene Kante (22) gegenüber der Horizontalen einen Winkel von 45° bildet.

5. Gehäuse nach Anspruch 3, dadurch gekennzeichnet, daß die Zunge mehrere Zähne (45) aufweist, die spitze Winkel bilden und zur Abstützung an den Rändern der Aufnahme dienen, in die die Zunge eingeführt wird.

6. Gehäuse nach Anspruch 2, dadurch gekennzeichnet, daß die weiblichen Steckverbinderteile (40) jeweils aus zwei Elementen (46) bestehen, die längs einer Seite mittels einer kleinen Verbindungsplatte (48) miteinander verbunden sind und an der entgegengesetzten Seite spitzwinklige Zähne (45) besitzen und daß der untere Teil (52) jedes Elements so geformt ist, daß die beiden einander gegenüberliegenden unteren Teile eine elastische Klemme bilden.

7. Gehäuse nach einem der Ansprüche 1 bis 6 mit flexiblen gedruckten Schaltungen, die auf einer Seite eine Isolierstoffabdeckung (9) aufweisen, wobei in dieser Isolierstoffabdeckung um die Durchtrittsöffnungen (8) für die Verbindungsorgane (14) herum Ausnehmungen gebildet sind, dadurch gekennzeichnet, daß an jeder Platte (4) eine Zone (10) vorgesehen ist, die beidseitig keine Isolierstoffabdeckung besitzt und das Biegen der Platte in dieser Zone erfolgt, und daß eines der Sockelteile auf annähernd der ganzen zwischen einem Rand und der Biegungszone liegenden Fläche der Platte befestigt ist, während das zweite Sockelteil an einem Teil der verbleibenden Fläche der Platte befestigt ist.

8. Gehäuse nach einem der vorhergehenden Ansprüche, dadurch gekennzeichnet, daß ein auf der Seite des zweiten Sockelteils angeordnetes Deckelteil vorgesehen ist, das eine breite Öffnung für den Zugang der Verbindungsorgane des zweiten Sockelteils sowie längs des äußeren Umfangs verteilte Verhakungsmittel aufweist, die mit an dem äußeren Umfang des ersten Sockelteils vorgesehenen Aufnahmeelementen zusammenwirken.

9. Gehäuse nach einem der Ansprüche 1 bis 8, dadurch gekennzeichnet, daß ein isophonischer Schirm (36) aus dielektrischem Material zwischen der oder jeder Platte und wenigstens einem der Sockelteile angeordnet ist.

10. Gehäuse nach einem der Ansprüche 1 bis 9, dadurch gekennzeichnet, daß eine Schutzhaube für Sicherungen und wenigstens ein Relais vorgesehen ist, die in zugeordnete Aufnahmen eingesetzt sind.

11. Gehäuse nach Anspruch 7, dadurch gekennzeichnet, daß der Isolierstoff der Abdeckung aus einem wärmehärtbaren, spritzbaren Material, z. B. aus glasfaserverstärktem Polyester, besteht.

FIG_1

FIG. 2a

FIG. 2b

FIG.3

FIG.4

_FIG_5_

_FIG_6_

_FIG_7_

FIG.8

FIG.9